# EUROPEAN PATENT SPECIFICATION

(11) **EP 4 383 351 B1**
(45) Date of publication and mention of the grant of the patent: **25.03.2026**
(21) Application number: 23167462.3
(22) Date of filing: 12.04.2023
(51) Int. Cl.: H10F 71/00, H10F 77/14, H10F 77/20

(54) **SOLAR CELL**
SOLARZELLE
CELLULE SOLAIRE

(30) Priority: 07.12.2022 CN 202211569073
(43) Date of publication of application: 12.06.2024
(73) Proprietor: ZHEJIANG JINKO SOLAR CO., LTD., Haining, Zhejiang 314416 (CN); JINKO SOLAR CO., LTD, ShangRao, Jiangxi 334100 (CN)
(72) Inventor: WANG, Zhao, Zhejiang, 314416 (CN); ZHENG, Peiting, Zhejiang, 314416 (CN); YANG, Jie, Zhejiang, 314416 (CN); ZHU, Jiajia, Zhejiang, 314416 (CN); ZHU, Simin, Zhejiang, 314416 (CN)
(74) Representative: Balder IP Law, S.L.

(56) References cited:
- WO-A1-2022/073628
- CN-A- 115 799 358
- US-A1- 2014 170 800

## Description

### TECHNICAL FIELD

Embodiments of the present disclosure relate in general to solar cell technology, and more particularly to a solar cell, a method for preparing the same, and a photovoltaic module.

### BACKGROUND

Solar cells have good photoelectric conversion ability. In the solar cells, doped layers are formed on a surface of a substrate, such as an emitter or a doping film with passivation effect. The emitter can form a PN junction with the substrate, and the doping film with passivation effect can be used to inhibit carrier recombination on the surface of the substrate of the solar cell and enhance the passivation effect on the substrate. In addition, metal electrodes used to collect carriers also need to be prepared in the solar cell. Generally, the metal electrodes are electrically connected to the doped layer to collect the carriers.

However, the poor contact performance between conventional metal electrodes and the doped layer leads to a large contact recombination loss of the metal electrodes, which leads to poor photoelectric conversion performance of the solar cell.

Patent Application US 20140170800A1 discloses a relevant technology regarding a method for fabricating solar cell emitter regions using silicon nano-particles and the resulting solar cells.

Patent Application WO 2022073628A1 discloses a relevant technology regarding a back contact structure of a solar cell, aiming at solving the existing problems of a high trench width control requirement and a poor passivation effect.

Patent Application CN 115799358A discloses a relevant technology regarding a solar cell and a photovoltaic module, which at least help to improve the photoelectric conversion efficiency of the solar cell.

### SUMMARY

The invention is set out in the appended set of claims.

### BRIEF DESCRIPTION OF THE DRAWINGS

One or more embodiments are described as examples with reference to the figures in the accompanying drawings, and the examples do not constitute a limitation to the embodiments. The features in the accompanying drawings do not constitute proportion limitation unless otherwise stated.
FIG. 1 is a schematic cross-sectional structural diagram of a solar cell according to an embodiment of the present disclosure.
FIG. 2 is another schematic cross-sectional structural diagram of a solar cell according to an embodiment of the present disclosure.
FIG. 3 is still another schematic cross-sectional structural diagram of a solar cell according to an embodiment of the present disclosure.
FIG. 4 is a schematic structural diagram of a photovoltaic module according to an embodiment of the present disclosure.
FIG. 5 is a schematic cross-sectional structural diagram corresponding to an operation of providing a substrate in a method for preparing a solar cell according to an embodiment of the present disclosure.
FIG. 6 is a schematic cross-sectional structural diagram corresponding to an operation of forming an initial first tunneling layer in a method for preparing a solar cell according to an embodiment of the present disclosure.
FIG. 7 is a schematic cross-sectional structural diagram corresponding to an operation of forming an initial first doped conductive layer in a method for preparing a solar cell according to an embodiment of the present disclosure.
FIG. 8 is a schematic cross-sectional structural diagram corresponding to an operation of forming a dielectric layer in a method for preparing a solar cell according to an embodiment of the present disclosure.
FIG. 9 to FIG. 11 are schematic cross-sectional structural diagrams corresponding to an operation of performing a patterning process on a dielectric layer in a method for preparing a solar cell according to an embodiment of the present disclosure.
FIG. 12 is a schematic cross-sectional structural diagram corresponding to an operation of forming a first passivation contact structure in a method for preparing a solar cell according to an embodiment of the present disclosure.
FIG. 13 is a partial enlarged schematic diagram of the dotted box in FIG. 12.
FIG. 14 is a schematic cross-sectional structural diagram corresponding to an operation of forming a first passivation contact structure in a method for preparing a solar cell according to an embodiment of the present disclosure.
FIG. 15 is a schematic cross-sectional structural diagram corresponding to an operation of forming a doped layer in a method for preparing a solar cell according to an embodiment of the present disclosure.
FIG. 16 is a schematic cross-sectional structure diagram corresponding to an operation of forming a second passivation contact structure in a method for preparing a solar cell according to an embodiment of the present disclosure.
FIG. 17 is a schematic cross-sectional structural diagram corresponding to an operation of forming a first passivation layer and a second passivation layer in a method for preparing a solar cell according to an embodiment of the present disclosure.

### DETAILED DESCRIPTION OF THE EMBODIMENTS

It is seen from BACKGROUND that the conventional solar cell has the poor photoelectric conversion efficiency.

It is found that one of the reasons for resulting in the poor photoelectric conversion efficiency of the conventional solar cell may be as follows. Specifically, a surface of the substrate of the solar cell has a metal pattern region and a non-metal pattern region. For the metal pattern region in which a metal electrode needs to be disposed, contact recombination loss of the metal electrode needs to be reduced, and for the non-metal pattern region, parasitic absorption of incident light needs to be reduced to improve absorptivity of the incident light. For the non-metal pattern region, a doped layer is typically provided to form a PN junction with a substrate or to enhance transmission of carriers in the substrate in the non-metal pattern region. Generally, an area of the doped layer in the non-metal pattern region needs to be increased, so as to improve the carrier transmission capacity. However, if a textured structure is prepared in the non-metal pattern region of the surface of the substrate, film layers formed over the non-metal pattern region of the surface of the substrate may have poor flatness, which is not conducive to improving performance of the film layers. That is to say, structures of different film layers are unbale to be balanced in the conventional solar cell, so that other performance may be sacrificed while improving a certain performance of the solar cell. Therefore, overall photoelectric conversion performance of the solar cell is poor.

Embodiments of the present disclosure provides a solar cell in which the first passivation contact structure is disposed on the portion of the substrate corresponding to the metal pattern region. The metal pattern region is a region configured to form the metal electrode, that is, the metal electrode is in electrical contact with the first passivation contact structure, so as to reduce the contact recombination loss of the metal electrode and improve the performance of the solar cell.

Considering the problem that the first doped conductive layer may produce parasitic absorption of incident light, the doping layer is formed in the portion of the substrate corresponding to the non-metal electrode region, and the doping layer achieves the selective transmission of carriers or forms an internal electric field in the substrate. The doping layer and the substrate have the same material, which greatly reduces the parasitic absorption of incident light by the doping layer, and further improves the utilization rate of incident light. The first region and the second region of the non-metal pattern region and the metal pattern region are successively connected, and the substrate has a height in the second region between that in the first region and that in the metal pattern region, so that the surface of the substrate in the first region, the second region and the metal pattern region forms a step morphology. In this way, the top surface of the doping layer formed in the portion of the substrate corresponding to the first region and the second region also has a partial step morphology. Compared with the doping layer being a plane, the area of the doping layer is increased, which is conducive to increasing an action area of the doping layer, thereby ensuring high utilization of the incident light by the solar cell while reducing the contact recombination loss of the metal electrode, and further increasing an active area of the doped layer and improving the overall photoelectric conversion performance of the solar cell.

Embodiments of the present disclosure will be described in detail below with reference to the accompanying drawings. Those of ordinary skill in the art may understand that in the embodiments of the present disclosure, many technical details are set forth in order to make the reader better understand the present disclosure. However, the technical solutions set forth in the present disclosure may be implemented even without these technical details and various changes and modifications based on the following embodiments.

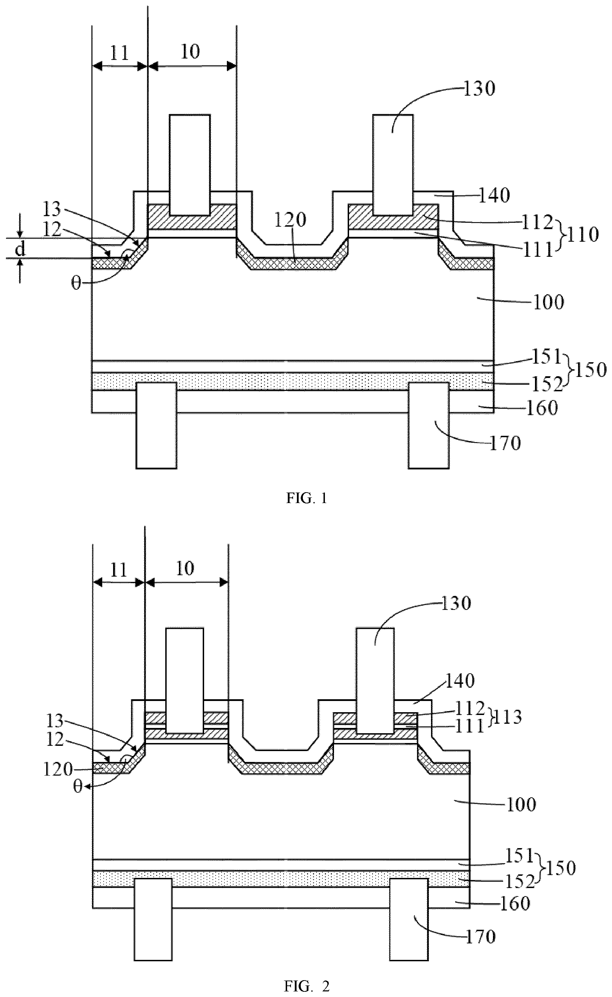

FIG. 1 is a schematic cross-sectional structural diagram of a solar cell according to an embodiment of the present disclosure.

Referring to FIG. 1, the solar cell includes a substrate 100, a doped layer 120, and a first passivation contact structure. The substrate 100 has a first surface and a second surface opposite to the first surface, and the first surface has a metal pattern region 10 and a non-metal pattern region 11. The non-metal pattern region 11 includes a first region 12 and a second region 13 adjacent to the first region and to the metal pattern region 10. The first surface of the substrate 100 in the first region 12 is lower than the first surface of the substrate 100 in the metal pattern region 10, and the first surface of the substrate 100 in the second region 13 is not lower than the first surface of the substrate 100 in the first region 12 and is not higher than the first surface of the substrate 100 in the metal pattern region 10. That is, the first region 12 of the first surface is closer to the second surface of the substrate 100 than the metal pattern region 10 of the first surface, and the second region 13 of the first surface is not closer to the second surface than the first region 12 of the first surface and is not further away from the second surface than the metal pattern region 10 of the first surface. The doped layer 120 is formed in a portion of the substrate 100 corresponding to the first region 12 and the second region 13, and the doped layer 120 has a top surface exposed out of the substrate 100. That is, the doped layer 120 has a top surface at the first region 12 and the second region 13. The first passivation contact structure 110 covers the metal pattern region 10 of the first surface, and the first passivation contact structure includes at least one first passivation contact substructure, and each of the at least one first passivation contact substructure includes a first tunneling layer and a first doped conductive layer stacked in a direction away from the substrate 100.

The first passivation contact structure 110 is only provided over the metal pattern region 10 of the first surface, so that the metal contact recombination between the first passivation contact structure 110 and a metal electrode is able to be reduced if the metal electrode is provided in the metal pattern region 10, thereby improving the carrier collection capability of the metal electrode.

The doped layer 120 is formed in the portion of the substrate 100 corresponding to the non-metal pattern region 11, that is, the doped layer 120 and the substrate 100 are of the same type of material, and the substrate 100 has a weak parasitic absorption capability on incident light, so that the parasitic absorption capability of the doped layer 120 on incident light is weak. Compared to the first passivation contact structure 110 also being provided over the non-metal pattern region 11 of the first surface of the substrate 100, the parasitic absorption of the non-metal pattern region 11 of the first surface of the substrate 100 on incident light is able to be reduced, thereby improving the utilization rate of incident light. Meanwhile, the doped layer 120 is also able to form a PN junction with the substrate 100 or achieve selective transmission of carriers.

The first region 12 and the second region 13 of the non-metal pattern region 11, and the metal pattern region 10 are successively connected, and a portion of the substrate 100 corresponding to the second region 13 has a height between a height of a portion of the substrate 100 corresponding to the first region 12 and a height of a portion of the substrate 100 corresponding to the metal pattern region 10, such that the first region 12, the second region 13, and the metal pattern region 10 form the first surface of a step shape. The doped layer 120 is formed in the portion of the substrate 100 corresponding to the first region 12 and the second region 13, and the top surface of the doped layer 120 is exposed out of the substrate 100 (i.e., the doped layer 120 has a top surface at the first region 12 and the second region 13), so that the top surface of the doped layer 120 also has a partial step morphology. Compared with the surface of the doped layer 120 being a flat surface, a surface area of the doped layer 120 is increased, thereby increasing an action area of the doped layer 120, and further improving the performance of the doped layer 120.

It is not difficult to find that the second region 13 is actually a transition region between the first region 12 and the metal pattern region 10, and it is the presence of the second region 13 that the surface area of the doped layer 120 is increased. In this way, the textured structure does not need to be prepared over the first region 12 of the non-metal pattern region 11 of the first surface, so that the surface area of the doped layer 120 is increased, and the first surface in the first region 12 is relatively flat. If the first passivation layer is formed over the first region 12 of the first surface, the flatness of the formed first passivation layer is improved, thereby improving the passivation performance of the first passivation layer on the first surface of the substrate 100, and further improving the photoelectric conversion performance of the solar cell.

In addition, the second region 13 is adjacent to the metal pattern region 10, so that an area of the doped layer 120 close to the metal pattern region 10 is relatively large. If the doped layer 120 plays a carrier transmission role, a path that carriers transmitting from the doped layer 120 to the first passivation contact structure 110 over the metal electrode portion 10 is relatively short, so that the transmission performance of carriers is enhanced.

In addition, the first surface of the substrate 100 has a step shape, which increases the surface area of the first surface of the substrate 100 in a height direction, so that the area of the doped layer 120 is increased while a cross-sectional area of the surface of the substrate 100 is not increased, thereby keeping assembly density of a photovoltaic module large when the solar cell is assembled to form the photovoltaic module, which is beneficial to keeping higher module power. The height direction herein refers to a direction in which the first passivation contact structure 110 points to the substrate 100, i.e., a direction perpendicular to the second surface of the substrate 100. The cross-sectional area is a cross-sectional area in a direction parallel to the second surface of the substrate 100.

In the embodiments of the present disclosure, the first region 12 and the second region 13 are provided in the non-metal pattern region 11, the first region 12, the second region 13 and the metal pattern region 10 form a step shape, and the doped layer 120 is formed in the portion of the substrate 100 corresponding to the first region 12 and the second region 13, so that the solar cell has a high utilization rate of incident light while the contact recombination loss of the metal electrode is reduced, the action area of the doped layer 120 is also increased, and the overall photoelectric conversion performance of the solar cell is improved. Through the structural arrangement of the doped layer 120, the surface of the substrate 100 having the step shape and the first passivation contact structure 110, advantages of the doped layer 120 and the first passivation contact structure 110 are exerted, adverse effects of the doped layer 120 and the first passivation contact structure 110 on other structures of the solar cell are reduced to a greater extent, and the overall performance of the solar cell is synergistically improved.

It should be noted that the height of the first surface in the first region 12 of the non-metal pattern region 11, the height of the first surface in the second region 13, and the height of the first surface in the metal pattern region 10 are all relative to the other opposite surface of the substrate 100 (i.e., the second surface). For example, if a surface on which the first passivation contact structure 110 is disposed is the first surface of the substrate 100, a surface of the substrate 100 away from the first passivation contact structure 110 is the second surface. The first surface and the second surface are opposite to each other. The height of the first surface in the first region 12 of the non-metal pattern region 11, the height of the first surface in the second region 13, and the height of the first surface in the metal pattern region 10 are all relative to the second surface. In other words, a thickness of a portion of the substrate 100 corresponding to the first region 12 is less than a thickness of a portion of the substrate 100 corresponding to the metal pattern region 10, and a thickness of a portion of the substrate 100 corresponding to the second region 13 is not less than the thickness of the portion of the substrate 100 corresponding to the first region 12, and is not greater than the thickness of the portion of the substrate 100 corresponding to the metal pattern region 10.

The substrate 100 is configured to receive incident light and generate photogenerated carriers. In some embodiments, a material of the substrate 100 may include at least one of monocrystalline silicon, polysilicon, amorphous silicon, or microcrystalline silicon. In some embodiments, a material of the substrate 100 may also include silicon carbide, an organic material, or multicomponent compounds. The multicomponent compounds may include, but are not limited to, materials such as perovskite, gallium arsenide, cadmium telluride, copper indium selenium, and the like.

In some embodiments, the solar cell is a Tunnel Oxide Passivated Contact (TOPCON) cell, the substrate 100 has two opposite surfaces, and the two opposite surfaces of the substrate 100 are able to be used to receive incident light or reflected light. In some embodiments, the substrate 100 includes a doping element, and a type of the doping element includes N-type or P-type. The N-type element may be group V elements such as phosphorus (P), bismuth (Bi), antimony (Sb), arsenic (As), or the like. The P-type element may be group III elements such as boron (B), aluminum (Al), gallium (Ga), indium (In), or the like. For example, when the substrate 100 is a P-type substrate, the type of the doping element in the substrate 100 is P-type. Alternatively, when the substrate 100 is an N-type substrate, the type of the doping element in the substrate 100 is N-type.

In some embodiments, the solar cell further includes a first electrode 130, and the first electrode 130 is electrically connected to a first doped conductive layer 112.

The photogenerated carriers generated in the substrate 100 are transmitted from the substrate 100 to the first doped conductive layer 112 and then transmitted to the first electrode 130, and the first electrode 130 is configured to collect photogenerated carriers. The first electrode 130 is disposed in the metal pattern region 10.

In some embodiments, the doped element in the first doped conductive layer 112 and the doped element in the doped layer 120 are congeners (i.e., elements of the same group). In some embodiments, the doped element in the first doped conductive layer 112 and the doped element in the doped layer 120 are both be a Group III element, for example, may be boron, gallium, or indium. In some embodiments, the doped element in the first doped conductive layer 112 and the doped element in the doped layer 120 are both Group V elements, for example, may be phosphorus, arsenic, or antimony.

That is, a type of the doped element in the first doped conductive layer 112 is the same as a type of the doped element in the doped layer 120, and may be both a P-type doped element or an N-type doped element. Moreover, the doped element in the first doped conductive layer 112 and the doped element in the doped layer 120 are provided as congeners, i.e., an outermost electron number of the doped element in the first doped conductive layer 112 is consistent with an outermost electron number of the doped element in the doped layer 120, so that chemical properties of the first doped conductive layer 112 and the doped layer 120 are similar, thereby enhancing the transmission performance of carriers from the doped layer 120 to the first doped conductive layer 112.

In some embodiments, a concentration of the doped element in the first doped conductive layer 112 is greater than or equal to a concentration of the doped element in the doped layer 120. In some embodiments, the concentration of the doped element in the first doped conductive layer 112 is greater than the concentration of the doped element in the doped layer 120, and is greater than a concentration of the doped element in the substrate 100. In this way, the first doped conductive layer 112 forms a heavily doped region relative to the substrate 100, so that carriers in the substrate 100 generate a barrier effect, the transmission capability of carriers from the substrate 100 to the first doped conductive layer 112 is enhanced while the tunneling capability of carriers in the first tunneling layer 111 is enhanced, which is conducive to increasing the carrier concentration and is conducive to collection of carriers by the first electrode 130.

The concentration of the doped element in the doped layer 120 is small, so that the doped layer 120 has a good surface passivation effect on the substrate 100. Moreover, a doping concentration difference between the concentration of the doped element in the doped layer 120 and the concentration of the doped element in the first doped conductive layer 112 is able to enhance lateral transmission of carriers between the doped layer 120 and the first doped conductive layer 112, thereby further improving the collection capability of carriers.

In some embodiments, the concentration of the doped element in the first doped conductive layer 112 is in a range of 1×10¹⁹atoms/cm³ to 9×10²⁰atoms/cm³, and the concentration of the doped element in the doped layer 120 is in a range of 1×10¹⁶atoms/cm³ to 1×10²⁰atoms/cm³. For example, in some embodiments, the concentration of the doped element in the first doped conductive layer 112 may be in a range of 1 ×10¹⁹atoms/cm³ to 5×10¹⁹atoms/cm³, 5 ×10¹⁹atoms/cm³ to 9×10¹⁹atoms/cm³, 9×10¹⁹atoms/cm³ to 1×10²⁰atoms/cm³, 1×10²⁰atoms/cm³ to 2×10²⁰atoms/cm³, 2×10²⁰atoms/cm³ to 4×10²⁰atoms/cm³, 4×10²⁰atoms/cm³ to 5×10²⁰atoms/cm³, 5×10²⁰atoms/cm³ to 6×10²⁰atoms/cm³, 6×10²⁰atoms/cm³ to 8×10²⁰atoms/cm³, or 8×10²⁰atoms/cm³ to 9×10²⁰atoms/cm³. In some embodiments, the concentration of the doped element in the doped layer 120 may be in a range of 1×10¹⁶atoms/cm³ to 5×10¹⁶atoms/cm³, 5×10¹⁶atoms/cm³ to 9×10¹⁶atoms/cm³, 9×10¹⁶atoms/cm³ to 1×10¹⁷atoms/cm³, 1×10¹⁷atoms/cm³ to 1×10¹⁸atoms/cm³, 1×10¹⁸atoms/cm³ to 5×10¹⁸atoms/cm³, 5×10¹⁸atoms/cm³ to 9×10¹⁸atoms/cm³, 9×10¹⁸atoms/cm³ to 1×10¹⁹atoms/cm³, 1×10¹⁹atoms/cm³ to 5×10¹⁹atoms/cm³, 5×10¹⁹atoms/cm³ to 9×10¹⁹atoms/cm³, or 9×10¹⁹atoms/cm³ to 1×10²⁰atoms/cm³. Within the above ranges, the concentration of the doped element in the first doped conductive layer 112 is large, which is conducive to enhancing the transmission of carriers in the first doped conductive layer 112 and the tunneling of carriers in a first tunneling layer 111. Moreover, within the above ranges, the concentration of the doped element in the doped layer 120 is small, so that the doped layer 120 has a good surface passivation effect on the first surface of the substrate 100 in the non-metal pattern region 11, and the carrier recombination on the first surface of the substrate 100 in the non-metal pattern region 11 is reduced.

In addition, within the above ranges, the concentration of the doped element in the first doped conductive layer 112 is greater than the concentration of the doped element in the doped layer 120, so that the first doped conductive layer 112 is also able to form a heavily doped region relative to the doped layer 120, thereby enabling carriers in the doped layer 120 to generate a barrier effect, and enhancing the transmission capability of carriers from the doped layer 120 to the first doped conductive layer 112, which is conducive to enhancing the collection capability of carriers.

In some embodiments, the concentration of the doped element in the doped layer 120 is equal to the concentration of the doped element in the first doped conductive layer 112.

In some embodiments, the type of the doped element in the doped layer 120 is different from the type of the doped element in the substrate 100. That is, the doped layer 120 serves as an emitter and forms a PN junction with the substrate 100. The PN junction is used to receive incident light and generate photogenerated carriers, the generated photogenerated carriers are transmitted from the substrate 100 to the first doped conductive layer 112 and then transmitted to the first electrode 130, and the first electrode 130 is configured to collect the photogenerated carriers. The photogenerated carriers may also be transmitted in the doped layer 120, i.e., transmitted from the doped layer 120 to the first doped conductive layer 112, and then collected by the first electrode 130.

In some embodiments, the type of the doped element in the first doped conductive layer 112 is the same as the type of the doped element in the doped layer 120, that is, the type of the doped element in the first doped conductive layer 112 is also different from the type of the doped element in the substrate 100, so that the first doped conductive layer 112 is also able to form a PN junction with the substrate 100, thereby increasing the number of generated photogenerated carriers, and improving concentration of the carriers, the filling factor, and a short-circuit current and an open-circuit voltage.

Compared to that the first doped conductive layer 112 is disposed over both the non-metal pattern region 11 and the metal pattern region 10 of the first surface of the substrate 100 to form a PN junction with the substrate 100, or compared to that the doped layer 120 is disposed in the non-metal pattern region 11 and the metal pattern region 10 of the first surface of the substrate 100 to serve as the emitter, the arrangement of the first doped conductive layer 112 being only disposed over the metal pattern region 10 of the first surface to form a PN junction with the substrate 100 and the first electrode 130 being electrically connected to the first doped conductive layer 112 reduces the metal contact recombination of the first electrode 130, and improve the carrier collection capability of the first electrode 130. While comparing to providing the first doped conductive layer 112, the arrangement of the doped layer 120 being provided in the portion of the substrate 100 corresponding to the non-metal pattern region 11, the doped layer 120 and the substrate 100 forming a PN junction, and the material of the doped layer 120 being the same as that of the substrate 100 greatly reduces the parasitic absorption of the portion of the substrate 100 corresponding to the non-metal pattern region 11 on incident light, thereby improving the utilization rate of incident light.

In some embodiments, both the type of the doped element in the doped layer 120 and the type of the doped element in the first doped conductive layer 112 are P-type, for example, may be phosphorus, bismuth, antimony, or arsenic, and the type of the doped element in the substrate 100 is N-type, for example, may be boron, gallium, or gallium.

In some embodiments, the concentration of the doped element in the doped layer 120 is greater than the concentration of the doped element in the substrate 100. In other words, the concentration of the doped element in the doped layer 120 is greater than the concentration of the doped element in a portion of the substrate 100 other than the doped layer 120. In this way, the doped layer 120 is heavily doped than the portion of the substrate 100 other than the doped layer 120, so that a concentration gradient of the same type of doped element is established between the doped layer 120 and the portion of the substrate 100 other than the doped layer 120, so as to form a rear electric field, and the presence of the rear electric field allows effective collection of photogenerated carriers.

It should be understood that since the doped layer 120 is disposed in a portion of the substrate 100 corresponding to the first region 12 and the second region 13, a top surface of the doped layer 120 has a partial step morphology, thereby increasing the surface area of the doped layer 120. And if the doped layer 120 serves as the emitter of the solar cell, the area of the formed PN junction is accordingly increased, so that the number of photogenerated carriers generated by the PN junction is increased, the carrier concentration is further improved, and the open-circuit voltage and the short-circuit current are improved.

In some embodiments, if the doped layer 120 serves as the PN junction, the doped layer 120 needs to be in contact with the incident light as much as possible, so that more incident light irradiates the top surface of the doped layer 120. Based on this, the first surface of the substrate 100 in the second region 13 is inclined relative to the first surface of the substrate 100 in the first region 12, and an included angle formed between the first surface of the substrate 100 in the second region 13 and the first surface of the substrate 100 in the first region 12 is an obtuse angle, so that the first surface of the substrate 100 in the second region 13 is exposed to the outside as much as possible, thereby reducing the shielding of the first surface of the substrate 100 in the second region 13, and further improving the utilization rate of the incident light by the substrate 100.

In addition, compared to that the first surface of the substrate 100 in the second region 13 is perpendicular to the first surface of the substrate 100 in the first region 12, the arrangement of the first surface of the substrate 100 in the second region 13 being inclined relative to the first surface of the substrate 100 in the first region 12, a surface area of the first surface of the substrate 100 in the second region 13 is increased when the height difference between the first surface of the substrate 100 in the first region 12 and the first surface of the substrate 100 in the metal pattern region 10 is certain, thereby further increasing the surface area of the doped layer 120.

In some embodiments, a first included angle θ is formed between the first region 12 and the second region 13 of the first surface of the substrate 100, and the first included angle θ is in a range of 90° to 160°, for example, 90° to 95°, 95° to 100°, 100° to 105°, 105° to 110°, 110° to 115°, 115° to 120°, 120° to 125°, 125° to 130°, 130° to 135°, 135° to 140°, 140° to 145°, 145° to 150°, 150° to 155° or 155° to 160°. Within the above ranges, the first surface of the substrate 100 in the second region 13 is inclined relative to the first surface of the substrate 100 in the first region 12, so that the first surface of the substrate 100 in the second region 13 has a large surface area, thereby further increasing the surface area of the doped layer 120. And if the doped layer 120 serves as the emitter of the solar cell, the area of the formed PN junction is increased, thereby generating more photogenerated carriers and improving the photoelectric performance of the solar cell.

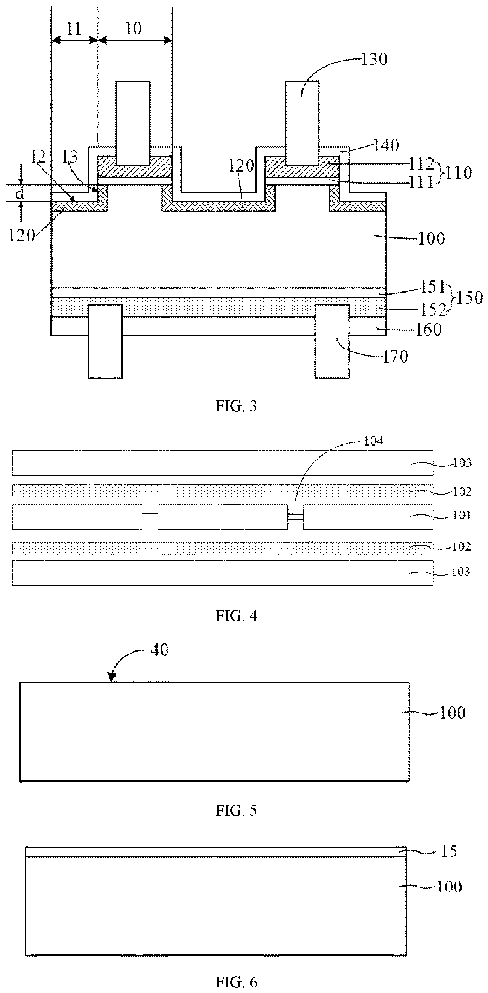

Referring to FIG. 3, in some embodiments, the first surface of the substrate 100 in the first region 12 is perpendicular to the first surface of the substrate 100 in the second region 13.

Referring to FIG. 1 and FIG. 3, in some embodiments, a height difference 'd' between the metal pattern region 10 and the first region 12 of the first surface of the substrate 100 is in a range of 0.1 µm to 10µm, for example, 01µm to 0.2µm, 0.2µm to 0.5µm, 0.5µm~1µm, 1µm to 1.5µm, 1.5µm to 2µm, 2µm to 2.5µm, 2.5µm to 3µm, 3µm to 3.1µm, 3.1µm to 3.2µm, 3.2µm to 3.5µm, 3.5µm to 3.8µm, 3.8µm to 3.9µm, 3.9µm to 4µm, 4µm to 4.5µm, 4.5µm to 5µm, 5 µm to 5.5µm, 5.5µm to 6µm, 6µm to 6.5µm, 6.5µm to 7µm, 7µm to 7.5µm, 7.5µm to 8µm, 8µm to 8.5µm, 8.5µm to 9µm, or 9µm to 10µm. Within the above ranges, on the one hand, the height difference 'd' between the first region 12 and the metal pattern region 10 of the first surface of the substrate 100 is large, so that the first surface of substrate 100 in the second region 13 has a large surface area, thus making the surface area of the doping layer 120 larger and improving the capability of the doped layer 120 to generate photogenerated carriers when serving as the emitter. On the other hand, the height difference 'd' between the first region 12 and the metal pattern region 10 of the first surface of the substrate 100 is not excessively large, so that the problem of too much defect state density on the first surface of the substrate 100 due to excessive etching of the substrate 100 in the process of actually forming the first region 12, the second region 13 and the metal pattern region 10 of the first surface of the substrate 100 is avoided, thus the carrier recombination on the first surface of the substrate 100 is less, which is conducive to improving the filling factor of the solar cell.

In some embodiments, a concentration of the doped element in a portion of the doped layer 120 corresponding to the second region 13 is not less than a concentration of the doped element in a portion of the doped layer 120 corresponding to the first region 12, and is not greater than a concentration of the doped element in the first doped conductive layer 112.

In some embodiments, the concentration of the doped element in the portion of the doped layer 120 corresponding to the second region 13 is greater than the concentration of the doped element in the portion of the doped layer 120 corresponding to the first region 12, and the concentration of the doped element in the portion of the doped layer 120 corresponding to the second region 13 is less than the concentration of the doped element in the first doped conductive layer 112. In other words, the concentration of the doped element in the portion of the doped layer 120 corresponding to the second region 13 is between the concentration of the doped element in the portion of the doped layer 120 corresponding to the first region 12 and the concentration of the doped element in the first doped conductive layer 112. If the carriers are transmitted between the doping layer 120 and the first doped conductive layer 112, the presence of the portion of the doping layer 120 corresponding to the second region 13 avoids low efficiency of carrier lateral transmission caused by excessively large potential energy difference between the portion of the doping layer 120 corresponding to the first region 12 and the first doping conductive layer 112 over the metal pattern region 10 due to the carrier transmission in the first doped conductive layer 112 and the doping layer 120 which have a large difference in the concentration of the doped element. That is to say, the portion of the doped layer 120 corresponding to the second region 13 plays a transition role, which reduces the potential energy difference of the carriers transmitted between the portion of the doped layer 120 corresponding to the first region 12 and the first doped conductive layer 112, thereby ensuring the validity of the carrier lateral transmission and improving the filling factor of the solar cell.

In some embodiments, in a direction from a side of the portion of the doped layer 120 corresponding to the first region 12 facing the first doped conductive layer 112 toward a side of the portion of the doped layer 120 corresponding to the first region 12 away from the first doped conductive layer 112, i.e., in a direction approaching the second surface, a concentration of the doped element in the portion of the doped layer 120 corresponding to the second region 13 gradually decreases. The concentration of the doped element in the portion of the doped layer 120 corresponding to the second region 13 is gradually changed, so that the potential energy difference of the carriers transmitted between the portion of the doped layer 120 corresponding to the first region 12 and the first doped conductive layer 112 is further reduced, thereby improving the lateral transmission capability of carriers.

In addition, the height of the first surface of the substrate 100 in the second region 13 is not lower than the height of the first surface of the substrate 100 in the first region 12, such that the first surface of the substrate 100 in the second region 13 and the first surface of the substrate 100 in the first region 12 form a partial step morphology. For example, the first surface of the substrate 100 in the second region 13 is perpendicular or inclined relative to the first surface of the substrate 100 in the first region 12, that is, the first surface of the substrate 100 in the second region 13 has a height difference in a direction perpendicular to the first surface of the substrate 100 in the first region 12. In this way, in the process of doping the first surface of the substrate 100 in the first region 12 and the second region 13, a doped rate of the doped element in the portion of the substrate 100 corresponding to the second region 13 is inconsistent in the direction perpendicular to the first surface of the substrate 100 in the first region 12, thereby facilitating the formation of the portion of the doped layer 120 corresponding to the second region 13, in which the doped element is gradually changed, for example, facilitating the formation of the portion of the doped layer 120 corresponding to the second region 13, in which the doped element gradually decreases in the direction of the portion of the doped layer 120 corresponding to towards the first doped conductive layer 112, i.e., in the direction approaching the second surface.

In some embodiments, a concentration of the doped element at a side of the portion of the doped layer 120 corresponding to the second region 13 facing the first doped conductive layer 112 is different from a concentration of the doped element at a side of the portion of the doped layer 120 corresponding to the second region 13 away from the first doped conductive layer 112 by 1×10¹⁹atoms/cm³ to 8×10²⁰atoms/cm³, i.e., a concentration of the doped element at a side of the portion of the doped layer 120 corresponding to the second region 13 away from the second surface is different from a concentration of the doped element at a side of the portion of the doped layer 120 corresponding to the second region 13 closer to the second surface by 1 ×10¹⁹atoms/cm³ to 8 ×10²⁰atoms/cm³, for example, may be 1×10¹⁹atoms/cm³ to 3×10¹⁹atoms/cm³, 3×10¹⁹atoms/cm³ to 5×10¹⁹atoms/cm³, 5×10¹⁹atoms/cm³ to 7×10¹⁹atoms/cm³, 7×10¹⁹atoms/cm³ to 9×10¹⁹atoms/cm³, 9×10¹⁹atoms/cm³ to 1×10²⁰atoms/cm³, 1×10²⁰atoms/cm³ to 3×10²⁰atoms/cm³, 3 ×10²⁰atoms/cm³ to 5×10²⁰atoms/cm³, or 5×10¹⁹atoms/cm³ to 8×10²⁰atoms/cm³. Within the above ranges, it is ensured that the potential energy difference generated in the process of the carriers transmitting between the portion of the doped layer 120 corresponding to the first region 12 and the first doped conductive layer 112 is small, thereby ensuring the validity of the lateral transmission of carriers.

In some embodiments, the concentration of the doped element at the side of the portion of the doped layer 120 corresponding to the second region 13 facing the first doped conductive layer 112, i.e., the concentration of the doped element at the side of the portion of the doped layer 120 corresponding to the second region 13 away from the second surface, is equal to the concentration of the doped element in the first doped conductive layer 112, and the concentration of the doped element at the side of the portion of the doped layer 120 corresponding to the second region 13 away from the first doped conductive layer 112, i.e., the concentration of the doped element at the side of the portion of the doped layer 120 corresponding to the second region 13 closer to the second surface, is equal to the concentration of the doped element in the portion of the doped layer 120 corresponding to the first region 12. In this way, the potential energy difference of the carriers at a contact interface between the portion of the doped layer 120 corresponding to the second region 13 and the first doped conductive layer 112 is reduced, and the potential energy difference of the carriers at a contact interface of the portion of the doped layer 120 corresponding to the second region 13 and the portion of the doped layer 120 corresponding to the first region 12 is reduced, which are conducive to further improving the lateral transmission capability of carriers.

In some embodiments, the concentration of the doped element in the portion of the doped layer 120 corresponding to the second region 13 is equal to the concentration of the doped element in the portion of the doped layer 120 corresponding to the first region 12 and the concentration of the doped element in the first doped conductive layer 112.

By controlling the concentration of the doped element in the doped layer 120 corresponding to the first region 12 and the second region 13, a square resistance of the doped layer 120 is able to be adjusted. For example, when the concentration of the doped element in the overall doped layer 120 is low, the square resistance of the doped layer 120 is able to be adjusted to be large, so that carrier recombination centers on the surface of the doped layer 120 are less, the recombination of carriers on the surface of the doped layer 120 is reduced, and the carrier concentration is increased, thereby increasing the open-circuit voltage and the filling factor of the solar cell, and improving the conversion efficiency of the solar cell.

In some embodiments, the square resistance of the doped layer 120 is in a range of 80ohm/sq to 1000ohm/sq, for example, 80ohm/sq to 100ohm/sq, 100ohm/sq to 130ohm/sq, 130ohm/sq to 150ohm/sq, 150ohm/sq to 280ohm/sq, 280ohm/sq to 450ohm/sq, 450ohm/sq to 600ohm/sq, 600ohm/sq to 720ohm/sq, 720ohm/sq to 850ohm/sq, 850ohm/sq to 900ohm/sq, 900ohm/sq to 950ohm/sq, or 950ohm/sq to 1000ohm/sq. Within the above ranges, carrier recombination centers generated on the surface of the doped layer 120 are less, so that the carrier concentration is increased, and the transmission capability of the carriers is improved, thereby increasing the open-circuit voltage and the filling factor of the solar cell, and improving the conversion efficiency of the solar cell.

In some embodiments, the first surface of the substrate 100 is provided with a first texture structure in the metal pattern region 10 and a second texture structure in the non-metal pattern region 11, and a roughness of the first texture structure is greater than a roughness of the second texture structure. The roughness of the first texture structure is large, so that a surface area of the first surface of the substrate 100 in the metal pattern region 10 is large, and the first passivation contact structure 110 formed over the metal pattern region 10 of the first surface of the substrate 100 is able to maintain the morphology of the first surface of the substrate 100 in the metal pattern region 10. That is, a top surface of the first passivation contact structure 110 also has a large roughness, and the surface area of the first passivation contact structure 110 is increased, so that a contact area of the first electrode 130 formed in the first passivation contact structure 110 and the first passivation contact structure 110 is large, a contact resistance of the first electrode 130 is reduced, thereby improving the carrier transmission performance.

Since the first surface of the substrate 100 has the step morphology, the surface area of the first surface of the substrate 100 is increased in the height direction, and therefore, the roughness of the second texture structure is set to be small, so that the first surface of the substrate 100 in the non-metal pattern region 11 is relatively flat. In this way, if the first passivation layer is formed on the top surface of the doped layer 120 corresponding to the non-metal pattern region 11, the first passivation layer is able to uniformly cover the surface of the doped layer 120 in the process of forming the first passivation layer, so that the morphology of the first passivation layer is relatively flat, a morphology of an interface between the first passivation layer and the surface of the doped layer 120 is improved, and the interface state density is reduced. This not only helps to reduce the recombination of carriers on the surface of the doped layer 120 corresponding to the non-metal pattern region 11, but also enhances the tunneling capability of carriers, thereby increasing the number of carriers and improving the photoelectric conversion performance of the solar cell.

In some embodiments, the first texture structure includes a pyramid structure, and the second texture structure includes a platform protrusion structure. In some embodiments, the pyramid structure includes a tetrahedron, an approximate tetrahedron, a pentahedron, an approximate pentahedron, or the like. In some embodiments, the platform protrusion structure includes a base portion of the pyramid structure, i.e., a remaining bottom portion of the pyramid structure after removing a tip portion. In some embodiments, the second texture structure includes a platform protrusion-like structure, a top surface of the platform protrusion-like structure may be a flat plane or an inclined plane, and a bottom surface of the platform protrusion structure may be a polygonal plane, for example, may be a quadrilateral plane or a pentagonal plane.

Referring to FIG. 2, in some embodiments, the first passivation contact structure 110 includes a plurality of first passivation contact substructures 113 stacked in a direction away from the substrate 100, and each of the first passivation contact substructures 113 includes a first tunneling layer 111 and a first doped conductive layer 112 stacked in a direction away from the substrate 100. That is to say, each first tunneling layer 111 in the plurality of first tunneling layers 111 in the first passivation contact structure 110 is alternately stacked with each first doped conductive layer 112 in the plurality of first doped conductive layers 112 in the first passivation contact structure 110.

In some embodiments, the first passivation contact structure 110 include only one first tunneling layer 111 and one first doped conductive layer 112, and the first tunneling layer 111 is formed on the first surface of the substrate 100. The first tunneling layer 111 provides a tunneling channel for carriers and enhances the selective transmission capability of carriers.

In some embodiments, a material of the first doped conductive layer 112 includes at least one of amorphous silicon, polycrystalline silicon, and silicon carbide. In some embodiments, a material of the first tunneling layer 111 includes at least one of silicon oxide, aluminum oxide, silicon nitride, silicon oxynitride, amorphous silicon, or polycrystalline silicon.

Referring to FIG. 1, according to the present invention, the solar cell further includes a second passivation contact structure 150, the second passivation contact structure 150 is formed on a surface of the substrate 100 away from the first passivation contact structure 110, i.e., the second surface, and the second passivation contact structure 150 includes at least one second tunneling layer 151 and at least one second doped conductive layer 152 stacked in a direction away from the substrate 100.

A second doped conductive layer 152 has a field passivation effect, so that minority carriers escape from the interface, thereby reducing a concentration of minority carriers, and enabling a recombination rate of carriers at the interface of the substrate 100 to be relatively low, so that the open-circuit voltage, the short-circuit current and the filling factor of the solar cell are large, and the photoelectric conversion performance of the solar cell is improved.

In some embodiments, a type of the doped element in the first doped conductive layer 112 is different from a type of the doped element in the substrate 100, and a type of the doped element in the second doped conductive layer 152 is the same as the type of the doped element in the substrate 100. A concentration of the doped element in the second doped conductive layer 152 is greater than the concentration of the doped element in the substrate 100, and the second doped conductive layer 152 forms a high-low junction with the substrate 100, which is beneficial to forming the barrier effect of carriers, thereby enhancing the transmission of carriers.

The second tunneling layer 151 is configured to realize the interface passivation of the second surface of the substrate 100, which achieves a chemical passivation effect. Specifically, the interface defect state density of the second surface of the substrate 100 is reduced by saturating suspension keys on the second surface of the substrate 100, thereby reducing recombination centers on the second surface of the substrate 100

In some embodiments, the second passivation contact structure 150 includes only one second tunneling layer 151 and one second doped conductive layer 152 stacked in a direction away from the substrate 100

In some embodiments, the second passivation contact structure 150 includes a plurality of second passivation contact substructures stacked in a direction away from the substrate 100, and each of the plurality of second passivation contact substructures includes a second tunneling layer 151 and a second doped conductive layer 152 stacked in a direction away from the substrate 100. That is, each second tunneling layer 151 in the plurality of second tunneling layers 151 in the second passivation contact structure 150 is alternately stacked with each second doped conductive layer 152 in the plurality of second doped conductive layers 152 in the second passivation contact structure 150.

According to the present invention, the solar cell further includes a first passivation layer 140, and the first passivation layer 140 is disposed on a top surface of the doped layer 120 and a top surface and side surfaces of the first passivation contact structure 110.

The first passivation layer 140 is disposed on the top surface of the doped layer 120 corresponding to the first region 12 and the second region 13, so that a good passivation effect is achieved on the first surface of the substrate 100 in the non-metal pattern region 11. Better chemical passivation is performed on the suspension keys on the first surface of the substrate 100 in the non-metal pattern region 11, so that the defect state density of the first surface of the substrate 100 in the non-metal pattern region 11 is reduced, carrier recombination on the first surface of the substrate 100 in the non-metal pattern region 11 is inhibited, and the carrier concentration is improved.

The first passivation layer 140 is disposed on the top surface and the side surfaces of the first passivation contact structure 110, i.e., the first passivation layer 140 covers the top surface and the side surfaces of the first passivation contact structure 110, which has a better passivation effect on the first surface of the substrate 100 in the metal pattern region 10, the top surface and side surfaces of the first doped conductive layer 112 and side surfaces of the first tunneling layer 111, and inhibits the carrier recombination on the first surface of the substrate 100 in the metal pattern region 10, the carrier recombination on the surface of the first doped conductive layer 112 and the carrier recombination on the side surfaces of the first tunneling layer 111, improves the concentration of carriers in the first surface of the substrate 100 in the metal pattern region 10, the first doped conductive layer 112 and the first tunneling layer 111, and enhances the carrier collection capability of the first electrode 130.

In some embodiments, a height of a portion of the first passivation layer 140 on the top surface of the portion of the doped layer 120 corresponding to the first region 12 is lower than a height of the first passivation layer 140 over the metal pattern region 10, and a height of a portion of the first passivation layer 140 on the top surface of the portion of the doped layer 120 corresponding to the second region 13 is between the height of the portion of the first passivation layer 140 on the top surface of the portion of the doped layer 120 corresponding to the first region 12 and the height of the first passivation layer 140 over the metal pattern region 10, i.e., the top surface of the first passivation layer 140 also has a step morphology.

It should be understood that the height of the portion of the first passivation layer 140 on the top surface of the portion of the doped layer 120 corresponding to the first region 12 herein, the height of a portion of the first passivation layer 140 on the top surface of the portion of the doped layer 120 corresponding to the second region 13, and the height of the first passivation layer 140 over the metal pattern region 10 described here are all relative to the surface of the substrate 100 away from the first passivation layer 140, i.e., the second surface.

In some embodiments, the first passivation layer 140 includes a single-layer structure. In some embodiments, the first passivation layer 140 includes a multi-layer structure. In some embodiments, a material of the first passivation layer 140 includes at least one of silicon oxide, aluminum oxide, silicon nitride, or silicon oxynitride.

According to the present invention, the solar cell further includes a first electrode 130, and the first electrode 130 penetrates through the first passivation layer 140 to be electrically connected to the first doped conductive layer 112.

In some embodiments, the first electrode 130 penetrates through the first passivation layer 140 and the first doped conductive layer 112 to be electrically connected to the first tunneling layer 111.

According to the present invention, the solar cell further includes a second passivation layer 160, and the second passivation layer 160 is formed on a surface of the second passivation contact structure 150 away from the substrate 100. The second passivation layer 160 is configured to achieve a good passivation effect on the second surface of the substrate 100, reduce the defect state density of the second surface, and inhibit carrier recombination on the second surface of the substrate 100. The second passivation layer 160 also achieves a good anti-reflection effect, which is conducive to reducing the reflection of incident light and improving the utilization rate of incident light.

In some embodiments, the second passivation layer 160 includes a single-layer structure. In some embodiments, the second passivation layer 160 includes a multi-layer structure. In some embodiments, a material of the second passivation layer 160 includes at least one of silicon oxide, aluminum oxide, silicon nitride, or silicon oxynitride.

According to the present invention, the solar cell further includes a second electrode 170, and the second electrode 170 is disposed over the second surface of the substrate 100, and the second electrode 170 penetrates through the second passivation layer 160 to be electrically connected to the second doped conductive layer 152.

In the solar cell provided in the embodiments of the present disclosure, the doped layer 120 is provided in the substrate 100, and the doped layer 120 has the same material as the substrate 100, so that the parasitic absorption of incident light by the doped layer 120 is greatly reduced. The passivation contact structure is formed on a portion of the substrate 100 corresponding to the metal pattern region 10, and the passivation contact structure is able to reduce the contact recombination loss of the metal electrode. Moreover, the first region 12 and the second region 13 of the non-metal pattern region 11, and the metal pattern region 10 are sequentially connected to form the surface of the substrate 100 having a step morphology. In this way, the top surface of the doped layer 120 formed at the top of the substrate 100 also has a partial step morphology, which increases the area of the formed doped layer 120 and the action area of the doped layer 120, thereby ensuring the high utilization rate of the solar cell on incident light while reducing the contact recombination loss of the metal electrode, increasing the action area of the doped layer 120, and improving the overall photoelectric conversion performance of the solar cell.

### COMPARATION EXAMPLE

The comparation example provides a solar cell, and the difference between a structure of the solar cell provided in the comparation example and a structure of the solar cell provided in the embodiments of the present disclosure is as follows. Referring to FIG. 1, in the solar cell provided in the embodiments of the present disclosure, the non-metal pattern region 11 of the first surface of the substrate 100 has the first region 12 and the second region 13, the first region 12 of the first surface is lower than the metal pattern region 10 of the first surface relative to the second surface, and the height of the first surface of the substrate 100 in the second region 13 is not less than the height of the first surface of the substrate 100 in the first region 12 and is not greater than the height of the first surface of the substrate 100 in the metal pattern region 10, relative to the second surface. The doped layer 120 is formed in the portion of the substrate 100 corresponding to the first region 12 and the second region 13, the top surface of the doped layer 120 is exposed out of the substrate 100, and the first passivation contact structure 110 is provided on the first surface of the substrate 100 in the metal pattern region 10. In the comparation example, the surface of the substrate is a flat surface, the doped layer is formed in a portion of the substrate corresponding to the metal pattern region and in a portion of the substrate corresponding to the non-metal pattern region, and the top surface of the doped layer is exposed out of the substrate. By comparing experiments, it is found that parameters of the embodiments of the present disclosure and the comparation example are shown in Table 1.

**Table 1**

| | Open-circuit voltage /mV | Short-circuit current density /cm² | Filling factor/% | Conversion efficiency/% |
|---|---|---|---|---|
| Embodiments of the present disclosure | 722 | 41.51 | 83.34 | 24.98 |
| Comparation example | 709 | 41.66 | 83.11 | 24.54 |

It is seen from the table 1 that compared with the comparation example, the open-circuit voltage, the filling factor and the conversion efficiency of the solar cell in the embodiments of the present disclosure are higher. This is because, in the embodiments of the present disclosure, only the first doped conductive layer 112 is provided on the first surface of the substrate 100 in the metal pattern region 10, and the first electrode 130 is electrically connected to the first doped conductive layer 112, so that the metal contact recombination of the first electrode 130 is reduced, and the carrier collection capability of the first electrode 130 is improved. While comparing to providing the first doped conductive layer 112, the arrangement of the doped layer 120 being provided in the portion of the substrate 100 corresponding to the non-metal pattern region 11, and the material of the doped layer 120 being the same as that of the substrate 100 greatly reduces the parasitic absorption of the portion of the substrate 100 corresponding to the non-metal pattern region 11 on incident light, thereby improving the utilization rate of incident light. In addition, the first region 12, the second region 13, and the metal pattern region 10 of the first surface of the substrate 100 form a step morphology, which increases the area of the first surface of the substrate 100 in the non-metal pattern region 11 compared with the surface of the substrate 100 in the non-metal pattern region 11 in the comparation example, thereby increasing the portion of the doped layer 120 corresponding to the non-metal pattern region 11, ensuring that the doped layer 120 has a large action area while reducing the metal contact recombination of the metal pattern region 10, and further improving the photoelectric conversion performance of the solar cell.

Accordingly, another aspect of the embodiments of the present disclosure further provides a photovoltaic module. Referring to FIG. 4, the photovoltaic module includes at least one cell string, at least one encapsulation layer 102, and at least one cover plate 103. Each of the at least one string is formed by connecting a plurality of solar cells 101 each provided in the above embodiments. Each of the at least one encapsulation layer 102 configured to cover a surface of a respective cell string. Each of the at least one cover plate 103 configured to cover a surface of a respective encapsulation layer 102 facing away from the respective cell string. The solar cells 101 are electrically connected in whole or in pieces to form a plurality of cell strings electrically connected in series and/or in parallel.

Specifically, in some embodiments, the plurality of cell strings may be electrically connected to each other by conductive tapes 104. The encapsulation layers 102 covers the front surface and the rear surface (i.e., the first surface and the second surface) of the solar cell 100, respectively. Specifically, the encapsulation layer 102 may be an organic encapsulation adhesive film such as an ethylene-vinyl acetate copolymer (EVA) adhesive film, a polyethylene octene co-elastomer (POE) adhesive film, a polyethylene terephthalate (PET) adhesive film, or the like. In some embodiments, the cover plate 103 may be a glass cover plate, a plastic cover plate, or the like having a light transmitting function. Specifically, the surface of the cover plate 103 facing towards the encapsulation layer 102 may be a concavo-convex surface, thereby increasing utilization of the incident light.

Accordingly, a method for preparing a solar cell is further provided in the embodiments of the present disclosure, such method not being part of the present invention.

Referring to FIG. 5, a substrate 100 is provided, and substrate 100 has an initial surface 40 and a second surface opposite to the initial surface. The initial surface 40 has a metal pattern region and a non-metal pattern region. The metal pattern region is defined as an electrode region, and the non-metal pattern region is a region other than the metal pattern region of the surface of the substrate 100.

The substrate 100 is configured to receive incident light and generate photogenerated carriers, and both the front surface and the rear surface of the substrate 100 may be configured to receive incident light or reflected light. In some embodiments, the substrate 100 is a silicon substrate, and the material of the substrate 100 includes at least one of monocrystalline silicon, polycrystalline silicon, amorphous silicon, or microcrystalline silicon.

In some embodiments, the substrate 100 is an N-type semiconductor substrate, and the doped element in the substrate 100 includes any one of phosphorus, arsenic, or antimony.

In some embodiments, the substrate 100 is a P-type semiconductor substrate, and the doped element in the substrate 100 includes any one of boron, gallium, or indium.

In some embodiments, the solar cell is a TOPCON cell.

Referring to FIG. 6 to FIG. 8, a passivation contact structure basis 14 and a dielectric layer 20 are stacked in a direction away from the substrate 100 on the initial surface 40 (see FIG. 5) of the substrate 100. The passivation contact structure basis 14 is used as a basis for subsequently forming a first passivation contact structure, and the dielectric layer 20 is used as a mask for initial first passivation contact patterning for subsequently forming the first passivation contact structure.

Referring to FIG. 6 to FIG. 7, in some embodiments, the method for forming the passivation contact structure basis 14 includes forming at least one initial first tunneling layer 15 and at least one initial first doped conductive layer 16 stacked in the direction away from the substrate 100 on the initial surface 40 of the substrate 100.

In some embodiments, the passivation contact structure basis 14 includes only one initial first doped conductive layer 16 and one initial first tunneling layer 15, and the formed first passivation contact structure includes only one first doped conductive layer and one first tunneling layer.

In some embodiments, the passivation contact structure basis 14 includes a plurality of initial first doped conductive layers 16 and a plurality of initial first tunneling layers 15, and the initial first doped conductive layers 16 and the initial first tunneling layers 15 are alternately stacked in a direction away from the substrate 100. The formed first passivation contact structure includes a plurality of first doped conductive layers and a plurality of first tunneling layers, and the first doped conductive layers and the first tunneling layer are alternately stacked in a direction away from the substrate 100.

Referring to FIG. 6, in some embodiments, an initial first tunneling layer 15 is formed on the initial surface of the substrate 100 by a deposition process. The deposition process includes any of atomic layer deposition or chemical vapor deposition.

In some embodiments, the material of the initial first tunneling layer 15 includes at least one of silicon oxide, aluminum oxide, silicon nitride, silicon oxynitride, amorphous silicon, or polycrystalline silicon.

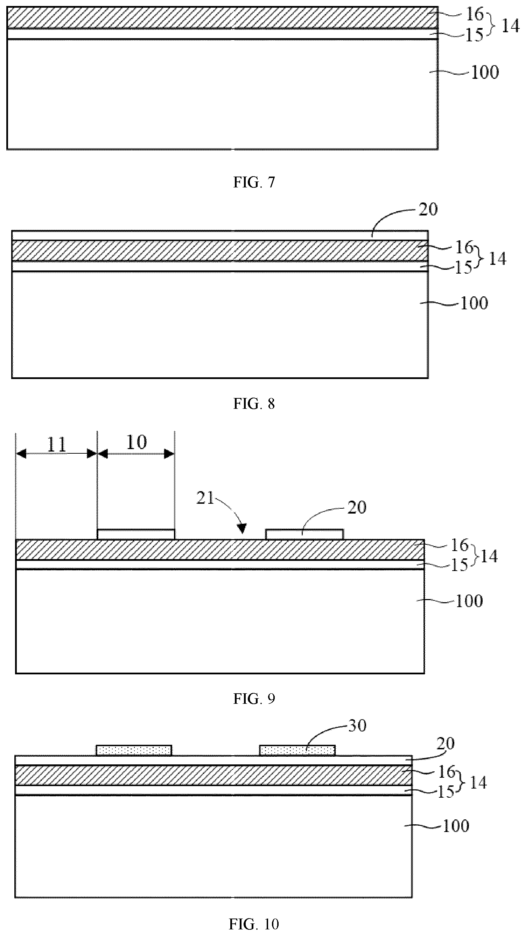

Referring to FIG. 7, in some embodiments, the method of forming the initial first doped conductive layer 16 includes forming a first doped layer on a surface of the initial first tunneling layer 15 by a deposition process, and implanting a doped element into the first doped layer by an in-situ deposition process during the deposition process to form an original first doped conductive layer. The deposition process and the process of implanting the doped element are performed at the same time, so that the process time is saved, and the process efficiency is improved.

After the doped element is implanted into the first doped layer, the original first doped conductive layer is annealed to form the initial first doped conductive layer 16. Through the annealing process, the doped element in the original first doped conductive layer is able to be activated to form an activated doped element. In some embodiments, a type of the doped element implanted in the first doped layer is different from the type of the doped element in the substrate 100, so that the formed first doped conductive layer forms a PN junction with the substrate 100. In some embodiments, the type of the doped element in the substrate 100 may be N-type, for example, may be boron, gallium, or gallium. The type of the doped element implanted in the first doped layer may be P-type, for example, may be phosphorus, bismuth, antimony, or arsenic.

In some embodiments, a material of the first doped layer includes any one of amorphous silicon, polysilicon, microcrystalline silicon, or silicon carbide.

Referring to FIG. 8, in some embodiments, the method for forming the dielectric layer 20 includes forming a dielectric layer 20 on the top surface of the initial first doped conductive layer 16 by a deposition process, and the material of the dielectric layer 20 includes any one of silicon oxide, silicon nitride, aluminum oxide, or silicon oxynitride. The deposition process includes one of an atomic layer deposition process or a vapor deposition process.

In some embodiments, the initial first doped conductive layer 16 and the dielectric layer 20 are formed in the same process. The method for forming the initial first doped conductive layer 16 and the dielectric layer 20 includes forming the first doped layer by a deposition process, depositing a doping source on the top surface of the first doped layer, the doping source including a first doped element, and introducing oxygen while depositing the doping source. Oxygen reacts with the first doped layer to form the dielectric layer 20, and the dielectric layer 20 has the first doped element. In some embodiments, the material of the first doped layer includes polysilicon, and oxygen reacts with polysilicon to generate silicon oxide. Oxygen further reacts with the first doped element. If the first doped element is boron, oxygen reacts with boron to generate boron oxide, silicon oxide reacts with boron oxide to form borosilicate glass, and the borosilicate glass forms the dielectric layer 20. In some embodiments, if the first doped element is phosphorus, a phosphorus-silicon glass layer is formed, and the phosphorus-silicon glass layer serves as the dielectric layer 20.

Referring to FIG. 9 to FIG. 11, the dielectric layer 20 is patterned to form a first opening 21 in the dielectric layer 20, and the first opening 21 is aligned with the non-metal pattern region 11.

Referring to FIG. 9, in some embodiments, the patterning process of the dielectric layer 20 includes performing laser processing on a portion of the dielectric layer 20 over the non-metal pattern region 11 by using a laser process to remove the portion of the dielectric layer 20 over the non-metal pattern region 11 to form a first opening 21, and the first opening 21 exposes the passivation contact structure basis 14 over the non-metal pattern region 11.

Compared with performing a patterning process on the dielectric layer 20 by a chemical etching process, the portion of the dielectric layer 20 over the non-metal pattern region 11 is removed by laser processing, thereby greatly simplifying the process and improving the process efficiency.

In some embodiments, a laser wavelength of the laser process is in a range of 248nm to 532nm, for example, 248nm to 255nm, 255nm to 275nm, 275nm to 290nm, 290nm to 315nm, 315nm to 340nm, 340nm to 355nm, 355nm to 370nm, 370nm to 405nm, 405nm to 445nm, 445nm to 480nm, 480nm to 495nm, 495nm to 505nm, 505nm to 520nm, or 520nm to 532nm. Within the above ranges, the laser energy used by the first laser process is sufficient to remove the portion of the dielectric layer 20 over the non-metal pattern region 11. Within the above ranges, the laser energy used by the first laser process is not too large, thereby preventing the problem of over-etching of the passivation contact structure basis 14 covered by the dielectric layer 20 due to excessive laser energy, and ensuring that the passivation contact structure basis 14 has a relatively flat surface.

Referring to FIG. 10 to FIG. 11, in some embodiments, the patterning process of the dielectric layer 20 includes forming an ink layer 30 on the top surface of the portion of the dielectric layer 20 over the metal pattern region 10, the ink layer 30 being aligned with the metal pattern region 10 (see FIG. 9), and performing acid pickling treatment on the dielectric layer 20 to remove the portion of the dielectric layer 20 over the non-metal pattern region 11 to form a first opening 21, the first opening 21 exposing the portion of the passivation contact structure basis 14 over the non-metal pattern region 11.

In the process of patterning the dielectric layer 20, the ink layer 30 is formed on a surface of a portion of the dielectric layer 20 that does not need to be removed. Since the ink layer 30 is able to be formed by processes such as coating, the pattern of the ink layer 30 is accurately controlled, thereby accurately controlling a size of the dielectric layer 20. Using the property that the ink layer 30 is insoluble in the acid, the portion of the dielectric layer 20 not covered by the ink layer 30 is removed by pickling treatment, so that a surface of the portion of the passivation contact structure basis 14 over the non-metal pattern region 11 is exposed. The patterning process of the passivation contact structure basis 14 is simplified through the above steps.

In some embodiments, the ink layer 30 is able to be formed on the surface of the portion of the dielectric layer 20 over the metal pattern region 10 by using any one of a screen-printing process, a spraying process or a 3D printing process. The formation of the ink layer 30 is relatively simple, and the pattern of the ink layer 30 is easy to control, which not only simplifies the process of patterning the dielectric layer 20, but also accurately controls the precision of the pattern of the formed ink layer 30, so that the morphology of each film layer in the finally formed solar cell meets the expectation, and further the photoelectric conversion performance of the solar cell meets the expectation.

In some embodiments, the method for pickling the dielectric layer 20 includes cleaning the surface of the dielectric layer 20 using any one of an HF solution or an HCl solution. The HF solution and the HCl solution have strong corrosivity, the dielectric layer 20 is able to be efficiently removed. In some embodiments, if the dielectric layer 20 is one of borosilicate glass or phosphorosilicate glass, a concentration of the HF solution or the HCl solution needs to be controlled to be large due to the fact that the property of the glass is relatively stable, for example, the portion of the dielectric layer 20 not covered by the ink layer 30 is able to be removed using the HF solution with a mass concentration of 50% to 70%.

In some embodiments, the HF solution or HCl solution is sprayed onto the surface of the dielectric layer 20 to remove the dielectric layer 20.

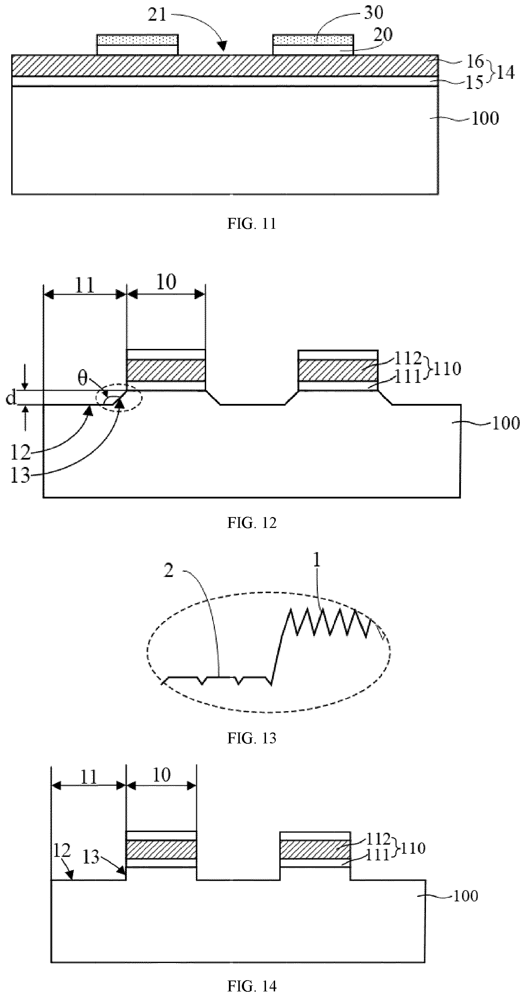

Referring to FIG. 12 and FIG. 14, the passivation contact structure basis 14 and the non-metal pattern region 11 of the initial surface 40 of the substrate 100 are etched at the first opening 21 to form a first surface of the substrate 100 having the non-metal pattern region 11 and the metal pattern region 10, and the non-metal pattern region 11 includes a first region 12 and a second region 13 adjacent to the first region and to the metal pattern region 10. The first region 12 of the first surface is lower than the metal pattern region 10 of the first surface, and the second region 13 of the first surface is not lower than the first region 12 of the first surface and is not higher than the metal pattern region 10 of the first surface. Remaining passivation contact structure basis 14 forms a first passivation contact structure 110.

It should be noted that the initial surface 40 of the substrate refers to a surface of the substrate 100 before etching the non-metal pattern region 11of the surface of the substrate 100, the formed first surface of the substrate 100 having the non-metal pattern region 11 and the metal pattern region 10 refers to a surface of the substrate 100 formed after a portion of the substrate 100 corresponding to the non-metal pattern region 11 is etched.

The first region 12 and the second region 13 of the non-metal pattern region 11, and the metal pattern region 10 are successively connected, and a portion of the substrate 100 corresponding to the second region 13 has a height between a height of a portion of the substrate 100 corresponding to the first region 12 and a height of a portion of the substrate 100 corresponding to the metal pattern region 10, such that the first region 12, the second region 13, and the metal pattern region 10 form the first surface of a step shape. In this way, after the doping process is subsequently performed at the first region 12 and the second region 13 of the first surface of the substrate 100 to form the doped layer, the top surface of the formed doped layer also has a partial step morphology. Compared with the surface of the doped layer being a flat surface, a surface area of the doped layer is increased, thereby improving the performance of the doped layer.

Referring to FIG. 14, in some embodiments, the first surface of the substrate 100 in the second region 13 is perpendicular to the first surface of the substrate 100 in the first region 12.

Referring to FIG. 12, in some embodiments, the first surface of the substrate 100 in the second region 13 is inclined relative to the first surface of the substrate 100 in the first region 12, a surface area of the first surface of the substrate 100 in the second region 13 is increased when a height difference between the first surface of the substrate 100 in the first region 12 and the first surface of the substrate 100 in the metal pattern region 10 is certain, thereby further increasing the surface area of the doped layer 120 subsequently formed in the portion of the substrate 100 corresponding to the first region 12 and the second region 13.

In some embodiments, a first included angle θ is formed between the first region 12 and the second region 13 of the first surface of the substrate 100, and the first included angle θ is in a range of 90° to 160°, for example, 90° to 95°, 95° to 100°, 100° to 105°, 105° to 110°, 110° to 115°, 115° to 120°, 120° to 125°, 125° to 130°, 130° to 135°, 135° to 140°, 140° to 145°, 145° to 150°, 150° to 155° or 155° to 160°.

In some embodiments, a height difference 'd' between the metal pattern region 10 and the first region 12 of the first surface of the substrate 100 is in a range of 0.1µm to 10µm, for example, 01µm to 0.2µm, 0.2µm to 0.5µm, 0.5µm~1µm, 1µm to 1.5µm, 1.5µm to 2µm, 2µm to 2.5µm, 2.5µm to 3µm, 3µm to 3.1µm, 3.1µm to 3.2µm, 3.2µm to 3.5µm, 3.5µm to 3.8µm, 3.8µm to 3.9µm, 3.9µm to 4µm, 4µm to 4.5µm, 4.5µm to 5µm, 5µm to 5.5µm, 5.5µm to 6µm, 6µm to 6.5µm, 6.5µm to 7µm, 7µm to 7.5µm, 7.5µm to 8µm, 8µm to 8.5µm, 8.5µm to 9µm, or 9µm to 10µm. Within the above ranges, the height difference 'd' between the first region 12 and the metal pattern region 10 of the first surface of the substrate 100 is large, so that the first surface of substrate 100 in the second region 13 has a large surface area, thus making the surface area of the doping layer 120 larger and improving the capability of the doped layer 120 to generate photogenerated carriers when serving as the emitter.

In some embodiments, the passivation contact structure basis 14 and the first surface of the substrate 100 in the non-metal pattern region 11 are able to be etched at the first opening 21 using a chemical etching process or a laser process.

In some embodiments, etching the passivation contact structure basis 14 and the first surface of the substrate 100 in the non-metal pattern region 11 at the first opening 21 using the laser process includes performing laser processing on the passivation contact structure basis 14 to expose the first surface of the substrate 100 in the non-metal pattern region 11. The exposed first surface of the substrate 100 in the non-metal pattern region 11 continues to be subjected to laser processing to form the first region 12 and the second region 13 in the non-metal pattern region 11, and the first region 12, the second region 13, and the metal pattern region 10 form the first surface of the substrate 100 having a step morphology.

In some embodiments, after the portion of the substrate 100 corresponding to the non-metal pattern region 11 is etched, the portion of the substrate 100 corresponding to the non-metal pattern region 11 is further subjected to a texturing process, so that the first surface of the substrate 100 in the non-metal pattern region 11 is relatively flat, which is beneficial to improving the flatness of the first passivation layer subsequently formed on the first surface of the substrate 100 in the non-metal pattern region 11.

In some embodiments, the first surface of the substrate 100 is provided with a first texture structure in the metal pattern region 10 and a second texture structure in the non-metal pattern region 11, and a roughness of the first texture structure is greater than a roughness of the second texture structure. The roughness of the first texture structure is large, so that a surface area of the first surface of the substrate 100 in the metal pattern region 10 is large, and the first passivation contact structure 110 formed over the metal pattern region 10 of the first surface of the substrate 100 is able to maintain the morphology of the first surface of the substrate 100 in the metal pattern region 10. In this way, a contact area between the first electrode subsequently formed in the first passivation contact structure and the first passivation contact structure is large, the contact resistance of the first electrode is reduced, and the transmission performance of carriers is improved.

Referring to FIG. 13, in some embodiments, the first texture structure 1 includes a pyramid structure, and the second texture structure includes a platform protrusion structure. In some embodiments, the pyramid structure includes a tetrahedron, an approximate tetrahedron, a pentahedron, an approximate pentahedron, or the like.

In some embodiments, before the operation of forming the passivation contact structure basis 14, the first texture structure 1 is formed on the first surface of the substrate 100, and the first texture structure 1 is formed on the first surface of the substrate 100 by using processes such as chemical etching, mechanical etching, or laser etching.

In some embodiments, the second texture structure 2 includes a platform protrusion structure, and the platform protrusion structure includes a base portion of the pyramid structure, i.e., a remaining bottom portion of the pyramid structure after removing a tip portion. In some embodiments, the second texture structure 2 includes a platform protrusion-like structure, a top surface of the platform protrusion-like structure may be a flat plane or an inclined plane, and a bottom surface of the platform protrusion structure may be a polygonal plane, for example, may be a quadrilateral plane or a pentagonal plane.

In some embodiments, the second texture structure 2 is formed on the first surface of the substrate 100 in the non-metal pattern region 11 by using processes such as chemical etching, mechanical etching, or laser etching.

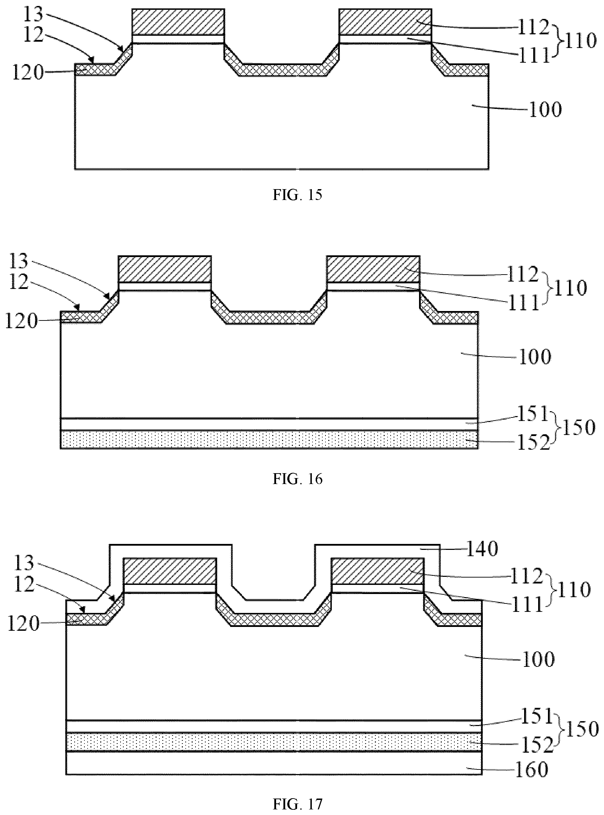

Referring to FIG. 15, a doping process is performed on the first surface of the substrate 100 in the first region 12 and the second region 13 to form the doped layer 120 in the substrate 100.

In some embodiments, performing a doping process at the first region 12 and the second region 13 of the first surface includes implanting a doped element at the first region 12 and the second region 13 of the first surface, so that the doped element is diffused into a portion of the substrate 100 corresponding to the first region 12 and the second region 13 to form an initial doped layer 120 having a preset thickness, and performing an annealing process on the initial doped layer 120 to form the doped layer 120. Since the doped layer 120 is formed in the substrate 100 corresponding to the first region 12 and the second region 13, the top surface of the doped layer 120 has a partial step morphology, thereby increasing the surface area of the doped layer 120 and improving the performance of the doped layer 120.

It is not difficult to find that the second region 13 is actually a transition region between the first region 12 and the metal pattern region 10, and it is the presence of the second region 13 that the surface area of the doped layer 120 is increased. In this way, the textured structure does not need to be prepared over the first region 12 of the non-metal pattern region 11 of the first surface, so that the surface area of the doped layer 120 is increased, and the first surface in the first region 12 is relatively flat. If the first passivation layer is formed over the first region 12 of the first surface, the flatness of the formed first passivation layer is improved, thereby improving the passivation performance of the first passivation layer on the first surface of the substrate 100, and further improving the photoelectric conversion performance of the solar cell.

In some embodiments, the concentration of the doped element in the doped layer 120 is less than the concentration of the doped element in the first doped conductive layer 112, so that the first doped conductive layer 112 is heavily doped than the doped layer 120, and then forms a high-low junction with the doped layer 120, so that carriers in the doped layer 120 generate a barrier effect, thereby improving the lateral transmission of carriers.

In some embodiments, the type of the doped element in the doped layer 120 is different from the type of the doped element in the substrate 100, and the type of the doped element in the doped layer 120 is the same as the type of the doped element in the first doped conductive layer 112. That is, the doped layer 120 serves as an emitter, and the doped layer 120 forms a PN junction with the substrate 100. The PN junction is used to receive incident light and generate photogenerated carriers, the generated photogenerated carriers are transmitted from the substrate 100 to the first doped conductive layer 112 and then transmitted to the first electrode 130, and the first electrode 130 is configured to collect the photogenerated carriers. The photogenerated carriers are transmitted in the doped layer 120, transmitted from the doped layer 120 to the first doped conductive layer 112, and then collected by the first electrode 130.

It should be understood that the first doped conductive layer 112 also forms a PN junction with the substrate 100, and a PN junction is formed between the first doped conductive layer 112 and the substrate 100 in the metal pattern region 10, so that the metal contact recombination between the first doped conductive layer 112 and the subsequently formed first electrode is reduced, and the carrier collection capability of the first electrode is improved. The doped layer 120 is formed in the portion of the substrate 100 corresponding to the non-metal pattern region 11 to form a PN junction with the substrate 100, which greatly reduces the parasitic absorption of incident light by the potion of the substrate 100 corresponding to the non-metal pattern region 11, thereby improving the utilization rate of incident light.

In some embodiments, a concentration of the doped element in the portion of the doped layer 120 corresponding to the second region 13 gradually decreases in a direction from a side of the portion of the doped layer 120 corresponding to the first region 12 facing the first passivation contact structure 110 toward a side of the portion of the doped layer 120 corresponding to the first region 12 away from the first passivation contact structure 110, i.e., in a direction approaching the second surface.

Since the first surface of the substrate 100 in the second region 13 and the first surface of the substrate 100 in the first region 12 form a partial step morphology, the first surface of the substrate 100 in the second region 13 is perpendicular or inclined relative to the first surface of the substrate 100 in the first region 12, that is, the first surface of the substrate 100 in the second region 13 has a height difference in a direction perpendicular to the first surface of the substrate 100 in the first region 12. In this way, in the process of doping the first surface of the substrate 100 in the first region 12 and the second region 13, a doped rate of the doped element in the portion of the substrate 100 corresponding to the second region 13 is inconsistent in the direction perpendicular to the first surface of the substrate 100 in the first region 12, thereby facilitating the formation of the portion of the doped layer 120 corresponding to the second region 13, in which the doped element is gradually changed, for example, facilitating the formation of the portion of the doped layer 120 corresponding to the second region 13, in which the doped element gradually decreases in the direction of the portion of the doped layer 120 corresponding to towards the first doped conductive layer 112, i.e., in the direction approaching the second surface. In this way, the potential energy difference of the carriers transmitted between the portion of the doped layer 120 in the first region 12 and the first doped conductive layer 112 is reduced, and the lateral transmission capability of the carriers is further improved.

The dielectric layer 20 is removed.

In some embodiments, the remaining part of the dielectric layer 20 is removed by an acid pickling process, for example, the remaining part of the dielectric layer 20 is cleaned using an HF solution or an HCl solution so as to remove the remaining part of the dielectric layer 20.

In some embodiments, if the ink layer 30 is formed on the surface of the portion the dielectric layer 20 over the metal pattern region 10 to pattern the dielectric layer 20, the ink layer 30 on the surface of the dielectric layer 20 needs to be removed before the operation of removing the dielectric layer 20. In some embodiments, the ink layer 30 over the metal pattern region 10 is treated with an alkaline solution, which saponifies with ester groups in the ink to dissolve the ink so as to remove the ink layer 30. In some embodiments, the alkaline solution, which includes NaOH solution or KOH solution, is sprayed onto the surface of the ink layer 30.

Referring to FIG. 16, in some embodiments, the method further includes forming a second passivation contact structure 150 on a surface of the substrate 100 away from the first passivation contact structure 110 (i.e., the second surface), and the second passivation contact structure 150 includes at least one second tunneling layer 151 and at least one second doped conductive layer 152 stacked in a direction away from the substrate 100.

In some embodiments, the second passivation contact structure 150 includes only one second tunneling layer 151 and one second doped conductive layer 152 stacked in a direction away from the substrate 100.

In some embodiments, the second passivation contact structure 150 includes a plurality of second passivation contact substructures stacked in a direction away from the substrate 100, and each second passivation contact structure includes a second tunneling layer 151 and a second doped conductive layer 152 stacked in a direction away from the substrate 100.

In some embodiments, the method for forming the second tunneling layer 151 refers to the description of the method for forming the initial first tunneling layer 15, the method for forming the second doped conductive layer 152 refers to the description of the method for forming the initial first doped conductive layer 16, and the difference lies in that the type of the doped element in the second doped conductive layer 152 is different from the type of the doped element in the first doped conductive layer 112.

Referring to FIG. 17, in some embodiments, the method further includes forming a first passivation layer 140 on a top surface of the doped layer 120 and a top surface and side surfaces of the first passivation contact structure 110 The first passivation layer 140 has a good passivation effect, inhibits carrier recombination, and improves the carrier concentration. In some embodiments, the first passivation layer 140 includes a single-layer structure. In some embodiments, the first passivation layer 140 includes a multi-layer structure. In some embodiments, a material of the first passivation layer 140 includes at least one of silicon oxide, aluminum oxide, silicon nitride, or silicon oxynitride.

In some embodiments, the method for forming the first passivation layer 140 includes forming the first passivation layer 140 on the top surface of the doped layer 120 and the top surface and side surfaces of the first passivation contact structure 110 using a Plasma Enhanced Chemical Vapor Deposition (PECVD) method.

In some embodiments, the method further includes forming a second passivation layer 160 on a surface of the second doped conductive layer 152, and the second passivation layer 160 has a good passivation effect. In some embodiments, the second passivation layer 160 includes a single-layer structure. In some embodiments, the second passivation layer 160 includes a multi-layer structure. In some embodiments, the material of the second passivation layer 160 includes at least one of silicon oxide, aluminum oxide, silicon nitride, or silicon oxynitride.

In some embodiments, the second passivation layer 160 is formed using a PECVD process.

Referring to FIG. 1, in some embodiments, the method further includes forming a first electrode 130. The first electrode 130 penetrates through the first passivation layer 140 to be electrically connected to the first doped conductive layer 112, and the first passivation contact structure 110 is disposed only on the first surface of the substrate 100 in the metal pattern region 10, so that the first electrode 130 is electrically connected to the first doped conductive layer 112, and metal contact recombination between the first passivation contact structure 110 and the metal electrode 130 is reduced, thereby improving the carrier collection capability of the metal electrode 130.

In some embodiments, the method for forming the first electrode 130 includes printing a conductive paste on a surface of a portion of the first passivation layer 140 over the metal pattern region 10, for example, a conductive paste is printed using a screen-printing process, and the conductive paste includes at least one of silver, aluminum, copper, tin, gold, lead, or nickel. The conductive paste on the surface of the portion of the first passivation layer 140 over the metal pattern region 10 is sintered, so that the conductive paste permeates in the portion of the first passivation layer 140 and part of the first doped conductive layer 112, so as to be electrically connected to the first doped conductive layer 112.

In some embodiments, the method further includes forming a second electrode 170. The second electrode 170 penetrates through the second passivation layer 160 and is electrically connected to the second doped conductive layer 152. In some embodiments, the process of forming the second electrode 170 is the same as the process of forming the first electrode 130, and reference is made to the above description of the method for forming the first electrode 130.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "has," "having," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

Although the present disclosure is disclosed in some embodiments, and is not intended to limit the claims, those of ordinary skill in the art are able to make several possible variations and modifications. Therefore, the protection scope of the present disclosure shall be subject to the scope defined by the claims of the present disclosure.

## Claims

1. A solar cell, comprising:
a substrate (100) having a first surface and a second surface opposite to the first surface, wherein the first surface has a metal pattern region (10) and a non-metal pattern region (11); and wherein:
the non-metal pattern region (11) includes a first region (12) and a second region (13) adjacent to the first region (12) and to the metal pattern region (10);
the first surface of the substrate in the first region (12) is closer to the second surface than the first surface of the substrate in the metal pattern region (10), and
the first surface of the substrate in the second region (13) is not closer to the second surface than the first surface of the substrate in the first region (12) and is not further away from the second surface than the first surface of the substrate in the metal pattern region (10); and
the substrate (100) has a doped layer (120) formed in a portion of the substrate (100) corresponding to the first region (12) and the second region (13), wherein the doped layer (120) has a top surface at the first region (12) and the second region (13);
a first passivation contact structure (110) covering the metal pattern region (10) of the first surface, wherein the first passivation contact structure (110) includes at least one first passivation contact substructure, and each of the at least one first passivation contact substructure includes a first tunneling layer (111) and a first doped conductive layer (112) stacked in a direction away from the substrate (100);
a second passivation contact structure (150) formed on the second surface of the substrate (100), wherein the second passivation contact structure (150) includes at least one second passivation contact substructure, and each of the at least one second passivation contact substructure includes a second tunneling layer (151) and a second doped conductive layer (152) stacked in a direction away from the substrate (100);
a first passivation layer (140), wherein the first passivation layer (140) covers a top surface of the doped layer (120) and a top surface and side surfaces of the first passivation contact structure (110);
a first electrode (130), wherein the first electrode (130) penetrates through the first passivation layer (140) to be electrically connected to the first doped conductive layer (112);
a second passivation layer (160) formed on a surface of the second passivation contact structure (150) away from the substrate (100); and
a second electrode (170) disposed over the second surface of the substrate (100), wherein the second electrode (170) penetrates through the second passivation layer (160) to be electrically connected to the second doped conductive layer (152).

2. The solar cell according to claim 1, wherein a doped element in the first doped conductive layer (112) and a doped element in the doped layer (120) are congeners, and a concentration of the doped element in the first doped conductive layer (112) is greater than or equal to a concentration of the doped element in the doped layer (120).

3. The solar cell according to claim 2, wherein the concentration of the doped element in the first doped conductive layer (112) is in a range of 1×10¹⁹atoms/cm³ to 9×10²⁰atoms/cm³, and the concentration of the doped element in the doped layer (120) is in a range of 1×10¹⁶atoms/cm³ to 1 ×10²⁰atoms/cm³.

4. The solar cell according to claim 2, wherein a type of the doped element in the doped layer (120) is different from a type of a doped element in the substrate (100), and the concentration of the doped element in the doped layer (120) is greater than a concentration of the doped element in the substrate (100).

5. The solar cell according to any one of claims 1 to 4, wherein a first included angle is formed between the first region (12) and the second region (13), and the first included angle is in a range of 90° to 160°.

6. The solar cell according to claim 5, wherein a concentration of the doped element in a portion of the doped layer (120) corresponding to the second region (13) is not less than a concentration of the doped element in a portion of the doped layer (120) corresponding to the first region (12), and is not greater than the concentration of the doped element in the first doped conductive layer (112).

7. The solar cell according to claim 6, wherein a concentration of the doped element in the portion of the doped layer (120) corresponding to the second region (13) gradually decreases in a direction approaching the second surface.

8. The solar cell according to claim 7, wherein a concentration of the doped element at a side of the portion of the doped layer (120) corresponding to the second region (13) away from the second surface is different from a concentration of the doped element at a side of the portion of the doped layer (120) corresponding to the second region (13) closer to the second surface by 1×10¹⁹atoms/cm³ to 8×10²⁰atoms/cm³.

9. The solar cell according to claim 7, wherein the doped layer (120) has a square resistance in a range of 80 ohm/sq to 1000 ohm/sq.

10. The solar cell according to claim 5, wherein a height difference between a height of the metal pattern region (10) relative to the second surface and a height of the first region (12) relative to the second surface is in a range of 0.1µm to 10µm.

11. The solar cell according to claim 1, wherein the first passivation contact structure (110) includes a plurality of first passivation contact substructures stacked in the direction away from the substrate (100).

12. A photovoltaic module, comprising:
at least one cell string, wherein each of the at least one string is formed by connecting a plurality of solar cells according to any one of claims 1 to 11;
at least one encapsulation layer (102), each of the at least one encapsulation layer configured to cover a surface of a respective cell string; and
at least one cover plate (103), each of the at least one cover plate configured to cover a surface of a respective encapsulation layer facing away from the respective cell string.

## Patentansprüche

1. Solarzelle, umfassend:
ein Substrat (100) mit einer ersten Oberfläche und einer zweiten Oberfläche gegenüber der ersten Oberfläche, wobei die erste Oberfläche einen Metallmusterbereich (10) und einen Nicht-Metallmusterbereich (11) aufweist; und wobei
der Nicht-Metallmusterbereich (11) einen ersten Bereich (12) und einen zweiten Bereich (13) benachbart zu dem ersten Bereich (12) und zu dem Metallmusterbereich (10) umfasst;
die erste Oberfläche des Substrats in dem ersten Bereich (12) näher an der zweiten Oberfläche liegt als die erste Oberfläche des Substrats in dem Metallmusterbereich (10), und
die erste Oberfläche des Substrats in dem zweiten Bereich (13) nicht näher an der zweiten Oberfläche liegt als die erste Oberfläche des Substrats in dem ersten Bereich (12) und nicht weiter von der zweiten Oberfläche entfernt liegt als die erste Oberfläche des Substrats in dem Metallmusterbereich (10); und
das Substrat (100) eine dotierte Schicht (120) aufweist, die in einem Teil des Substrats (100) entsprechend dem ersten Bereich (12) und dem zweiten Bereich (13) gebildet ist, wobei die dotierte Schicht (120) eine obere Oberfläche an dem ersten Bereich (12) und dem zweiten Bereich (13) aufweist;
eine erste Passivierungskontaktstruktur (110), die den Metallmusterbereich (10) der ersten Oberfläche bedeckt, wobei die erste Passivierungskontaktstruktur (110) mindestens eine Passivierungskontakt-Unterstruktur umfasst und jede der mindestens einen Passivierungskontakt-Unterstruktur eine erste Tunnelschicht (111) und eine erste dotierte leitfähige Schicht (112) umfasst, die in einer Richtung weg von dem Substrat (100) gestapelt sind;
eine zweite Passivierungskontaktstruktur (150), die auf der zweiten Oberfläche des Substrats (100) gebildet ist, wobei die zweite Passivierungskontaktstruktur (150) mindestens eine Passivierungskontakt-Unterstruktur umfasst und jede der mindestens einen Passivierungskontakt-Unterstruktur eine zweite Tunnelschicht (151) und eine zweite dotierte leitfähige Schicht (152) umfasst, die in einer Richtung weg von dem Substrat (100) gestapelt sind;
eine erste Passivierungsschicht (140), wobei die erste Passivierungsschicht (140) eine obere Oberfläche der dotierten Schicht (120) und eine obere Oberfläche und Seitenflächen der ersten Passivierungskontaktstruktur (110) bedeckt;
eine erste Elektrode (130), wobei die erste Elektrode (130) durch die erste Passivierungsschicht (140) hindurchdringt, um mit der ersten dotierten leitfähigen Schicht (112) elektrisch verbunden zu sein;
eine zweite Passivierungsschicht (160), die auf einer Oberfläche der zweiten Passivierungskontaktstruktur (150) weg von dem Substrat (100) gebildet ist; und
eine zweite Elektrode (170), die über der zweiten Oberfläche des Substrats (100) angeordnet ist, wobei die zweite Elektrode (170) durch die zweite Passivierungsschicht (160) hindurchdringt, um mit der zweiten dotierten leitfähigen Schicht (152) elektrisch verbunden zu sein.

2. Solarzelle nach Anspruch 1, wobei ein Dotierelement in der ersten dotierten leitfähigen Schicht (112) und ein Dotierelement in der dotierten Schicht (120) Kongenere sind und eine Konzentration des Dotierelements in der ersten dotierten leitfähigen Schicht (112) größer oder gleich einer Konzentration des Dotierelements in der dotierten Schicht (120) ist.

3. Solarzelle nach Anspruch 2, wobei die Konzentration des Dotierelements in der ersten dotierten leitfähigen Schicht (112) in einem Bereich von 1×10¹⁹ Atome/cm³ bis 9×10²⁰ Atome/cm³ liegt und die Konzentration des Dotierelements in der dotierten Schicht (120) in einem Bereich von 1×10¹⁶ Atome/cm³ bis 1×10²⁰ Atome/cm³ liegt.

4. Solarzelle nach Anspruch 2, wobei ein Typ des Dotierelements in der dotierten Schicht (120) von einem Typ eines Dotierelements in dem Substrat (100) verschieden ist und die Konzentration des Dotierelements in der dotierten Schicht (120) größer als eine Konzentration des Dotierelements in dem Substrat (100) ist.

5. Solarzelle nach einem der Ansprüche 1 bis 4, wobei ein erster eingeschlossener Winkel zwischen dem ersten Bereich (12) und dem zweiten Bereich (13) gebildet ist und der erste eingeschlossene Winkel in einem Bereich von 90° bis 160° liegt.

6. Solarzelle nach Anspruch 5, wobei eine Konzentration des Dotierelements in einem Teil der dotierten Schicht (120) entsprechend dem zweiten Bereich (13) nicht geringer als eine Konzentration des Dotierelements in einem Teil der dotierten Schicht (120) entsprechend dem ersten Bereich (12) ist und nicht größer als die Konzentration des Dotierelements in der ersten dotierten leitfähigen Schicht (112) ist.

7. Solarzelle nach Anspruch 6, wobei eine Konzentration des Dotierelements in dem Teil der dotierten Schicht (120) entsprechend dem zweiten Bereich (13) in einer Richtung, die sich der zweiten Oberfläche nähert, allmählich abnimmt.

8. Solarzelle nach Anspruch 7, wobei eine Konzentration des Dotierelements an einer Seite des Teils der dotierten Schicht (120) entsprechend dem zweiten Bereich (13) weg von der zweiten Oberfläche von einer Konzentration des Dotierelements an einer Seite des Teils der dotierten Schicht (120) entsprechend dem zweiten Bereich (13) näher an der zweiten Oberfläche um 1×10¹⁹ Atome/cm³ bis 8×10²⁰ Atome/cm³ verschieden ist.

9. Solarzelle nach Anspruch 7, wobei die dotierte Schicht (120) einen Schichtwiderstand in einem Bereich von 80 Ohm/sq bis 1000 Ohm/sq aufweist.

10. Solarzelle nach Anspruch 5, wobei eine Höhendifferenz zwischen einer Höhe des Metallmusterbereichs (10) relativ zu der zweiten Oberfläche und einer Höhe des ersten Bereichs (12) relativ zu der zweiten Oberfläche in einem Bereich von 0,1 µm bis 10 µm liegt.

11. Solarzelle nach Anspruch 1, wobei die erste Passivierungskontaktstruktur (110) eine Vielzahl von Passivierungskontakt-Unterstrukturen umfasst, die in der Richtung weg von dem Substrat (100) gestapelt sind.

12. Photovoltaikmodul, umfassend:
mindestens eine Zellenkette, wobei jede der mindestens einen Kette durch Verbinden einer Vielzahl von Solarzellen nach einem der Ansprüche 1 bis 11 gebildet ist;
mindestens eine Verkapselungsschicht (102), wobei jede der mindestens einen Verkapselungsschicht konfiguriert ist, um eine Oberfläche einer jeweiligen Zellenkette zu bedecken; und
mindestens eine Abdeckplatte (103), wobei jede der mindestens einen Abdeckplatte konfiguriert ist, um eine Oberfläche einer jeweiligen Verkapselungsschicht zu bedecken, die von der jeweiligen Zellenkette weg weist.

## Revendications

1. Cellule solaire comprenant :
un substrat (100) ayant une première surface et une seconde surface opposée à la première surface, la première surface ayant une région de motif métallique (10) et une région de motif non métallique (11) ; et
la région de motif non métallique (11) comprenant une première région (12) et une seconde région (13) adjacente à la première région (12) et à la région de motif métallique (10) ;
la première surface du substrat dans la première région (12) étant plus proche de la seconde surface que la première surface du substrat dans la région de motif métallique (10), et
la première surface du substrat dans la seconde région (13) n'étant pas plus proche de la seconde surface que la première surface du substrat dans la première région (12) et n'étant pas plus éloignée de la seconde surface que la première surface du substrat dans la région de motif métallique (10) ; et
le substrat (100) ayant une couche dopée (120) formée dans une partie du substrat (100) correspondant à la première région (12) et à la seconde région (13), la couche dopée (120) ayant une surface supérieure au niveau de la première région (12) et de la seconde région (13) ;
une première structure de contact de passivation (110) recouvrant la région de motif métallique (10) de la première surface, la première structure de contact de passivation (110) comprenant au moins une sous-structure de contact de passivation, et chacune de l'au moins une sous-structure de contact de passivation comprenant une première couche tunnel (111) et une première couche conductrice dopée (112) empilées dans une direction s'éloignant du substrat (100) ;
une seconde structure de contact de passivation (150) formée sur la seconde surface du substrat (100), la seconde structure de contact de passivation (150) comprenant au moins une sous-structure de contact de passivation, et chacune de l'au moins une sous-structure de contact de passivation comprenant une seconde couche tunnel (151) et une seconde couche conductrice dopée (152) empilées dans une direction s'éloignant du substrat (100) ;
une première couche de passivation (140), la première couche de passivation (140) recouvrant une surface supérieure de la couche dopée (120) et une surface supérieure et des surfaces latérales de la première structure de contact de passivation (110) ;
une première électrode (130), la première électrode (130) pénétrant à travers la première couche de passivation (140) pour être électriquement connectée à la première couche conductrice dopée (112) ;
une seconde couche de passivation (160) formée sur une surface de la seconde structure de contact de passivation (150) s'éloignant du substrat (100) ; et
une seconde électrode (170) disposée sur la seconde surface du substrat (100), la seconde électrode (170) pénétrant à travers la seconde couche de passivation (160) pour être électriquement connectée à la seconde couche conductrice dopée (152).

2. Cellule solaire selon la revendication 1, dans laquelle un élément dopé dans la première couche conductrice dopée (112) et un élément dopé dans la couche dopée (120) sont des congénères, et une concentration de l'élément dopé dans la première couche conductrice dopée (112) est supérieure ou égale à une concentration de l'élément dopé dans la couche dopée (120).

3. Cellule solaire selon la revendication 2, dans laquelle la concentration de l'élément dopé dans la première couche conductrice dopée (112) est dans une plage de 1×10¹⁹ atomes/cm³ à 9×10²⁰ atomes/cm³, et la concentration de l'élément dopé dans la couche dopée (120) est dans une plage de 1×10¹⁶ atomes/cm³ à 1×10²⁰ atomes/cm³.

4. Cellule solaire selon la revendication 2, dans laquelle un type de l'élément dopé dans la couche dopée (120) est différent d'un type d'un élément dopé dans le substrat (100), et la concentration de l'élément dopé dans la couche dopée (120) est supérieure à une concentration de l'élément dopé dans le substrat (100).

5. Cellule solaire selon l'une quelconque des revendications 1 à 4, dans laquelle un premier angle inclus est formé entre la première région (12) et la seconde région (13), et le premier angle inclus est dans une plage de 90° à 160°.

6. Cellule solaire selon la revendication 5, dans laquelle une concentration de l'élément dopé dans une partie de la couche dopée (120) correspondant à la seconde région (13) n'est pas inférieure à une concentration de l'élément dopé dans une partie de la couche dopée (120) correspondant à la première région (12), et n'est pas supérieure à la concentration de l'élément dopé dans la première couche conductrice dopée (112).

7. Cellule solaire selon la revendication 6, dans laquelle une concentration de l'élément dopé dans la partie de la couche dopée (120) correspondant à la seconde région (13) diminue progressivement dans une direction s'approchant de la seconde surface.

8. Cellule solaire selon la revendication 7, dans laquelle une concentration de l'élément dopé au niveau d'un côté de la partie de la couche dopée (120) correspondant à la seconde région (13) s'éloignant de la seconde surface est différente d'une concentration de l'élément dopé au niveau d'un côté de la partie de la couche dopée (120) correspondant à la seconde région (13) plus proche de la seconde surface de 1×10¹⁹ atomes/cm³ à 8×10²⁰ atomes/cm³.

9. Cellule solaire selon la revendication 7, dans laquelle la couche dopée (120) a une résistance carrée dans une plage de 80 ohm/sq à 1000 ohm/sq.

10. Cellule solaire selon la revendication 5, dans laquelle une différence de hauteur entre une hauteur de la région de motif métallique (10) par rapport à la seconde surface et une hauteur de la première région (12) par rapport à la seconde surface est dans une plage de 0,1 µm à 10 µm.

11. Cellule solaire selon la revendication 1, dans laquelle la première structure de contact de passivation (110) comprend une pluralité de sous-structures de contact de passivation empilées dans la direction s'éloignant du substrat (100).

12. Module photovoltaïque comprenant :
au moins une chaîne de cellules, chacune de l'au moins une chaîne étant formée en connectant une pluralité de cellules solaires selon l'une quelconque des revendications 1 à 11 ;
au moins une couche d'encapsulation (102), chacune de l'au moins une couche d'encapsulation étant configurée pour recouvrir une surface d'une chaîne de cellules respective ; et
au moins une plaque de couverture (103), chacune de l'au moins une plaque de couverture étant configurée pour recouvrir une surface d'une couche d'encapsulation respective faisant face à l'opposé de la chaîne de cellules respective.
